# EUROPEAN PATENT APPLICATION

(11) **EP 4 517 800 A1**
(43) Date of publication of application: **05.03.2025**
(21) Application number: 24162831.2
(22) Date of filing: 12.03.2024
(51) Int. Cl.: H01L 21/308, H01L 21/3065

(54) **PLASMA ETCHED COMPOUND SEMICONDUCTOR**

(30) Priority: 31.08.2023 GB 202313278
(71) Applicant: SPTS Technologies Limited, NP18 2TA (GB)
(72) Inventor: CROOT, Alex, Newport (GB)
(74) Representative: Wynne-Jones IP Limited

(57) **Abstract**

A method of plasma etching a silicon carbide substrate to form a tapered feature, a silicon carbide substrate and plasma etch apparatus for plasma etching a silicon carbide substrate to form a tapered feature are provided.

## Description

This invention relates to a method of plasma etching a feature in a compound semiconductor substrate. This invention also relates to a plasma etching apparatus.

### Background

There is growing demand for high power and high frequency devices based on compound semiconductors which cannot be met by conventional silicon-based technology. Wide band-gap compound semiconductors, such as silicon carbide (SiC), combine excellent electronic and thermal properties which can exceed those of silicon. However, fabricating such compound semiconductor devices in high volumes at an acceptable cost using known methods can be challenging, often requiring many processing steps. It is desirable to develop a method to fabricate compound semiconductor devices, such as SiC devices, in a more economical way with fewer processing steps.

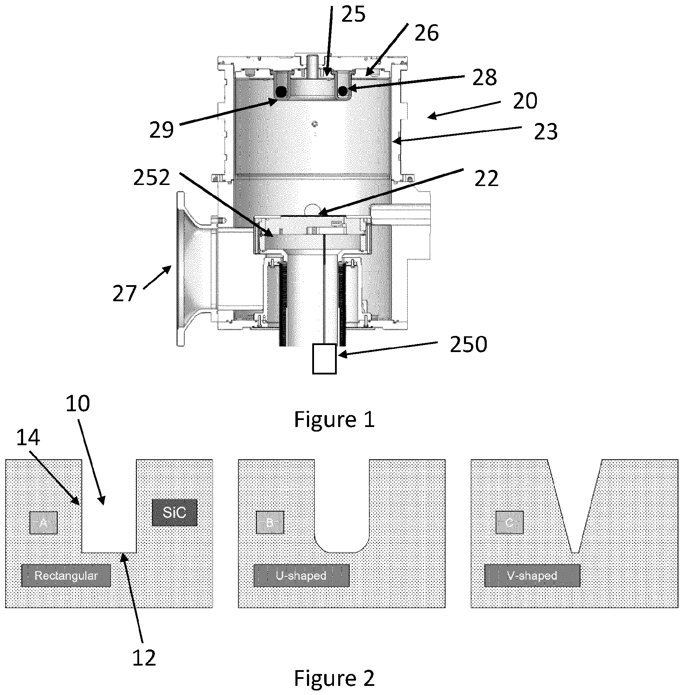

Power device silicon carbide trenches, typically dry etched silicon carbide trenches having a width of between 0.5 and 10 µm and a depth of between 0.5 and 3 µm, are finding an increasing number of applications in power semiconductor devices, predominantly in MOSFET gates where the trench is often coated in a Silicon Oxide (SiO_{X}) layer and then filled with polycrystalline Si. It is known to use flat-based, rectangular sectioned trenches as shown as trench A in Figure 2. The trench 10 has a substantially flat bottom surface 12 with substantially perpendicular sidewalls 14, as shown in Figure 2. However, micro-trenching at the bottom of flat-based trenches can cause problems. Micro-trenching refers to deeper etched sections at the corners of the trench. The acute angles inherent in micro-trenches can cause electric fields within the substrate to be concentrated at these locations, which can lead to reduced breakdown voltages. It is desirable to avoid micro-trenching; and to maximise the breakdown voltage.

Even in flat-bottomed trenches (without micro-trenching), the electric field is susceptible to "field bunching". That is, the electric field is susceptible to concentrating at a particular location within the trench, such as at the corners of trench. It is therefore desirable to minimise field bunching as far as possible by being able to control the curvature of the corners to the trench. Trenches with rounded corners, also known as a "U-shaped trench", have far more dispersed internal fields, increasing the breakdown voltage and meaning round-cornered trenches, as shown in exemplary trench B of Figure 2, will out-perform square-cornered alternatives in many devices.

A further promising trench morphology is a tapered side wall, or "V-shaped" trench, as shown in trench C of Figure 2. This shape allows the crystal orientations of the SiC to be harnessed by utilising the {0338} plane which has a higher channel mobility than other directions within the material, meaning channel resistance can be reduced. This improvement could give the V-shaped trench an advantage over other gate shapes for specific devices such as fast-switching MOSFETs in inverters. Currently, V-shaped trenches are produced by thermally activated etching in a chlorinated environment, which results in a trench with {0338} plane sidewalls. However, like thermal annealing, this process will have its own risks and throughput challenges. Perhaps even more significantly, the trench structure is limited to only this plane for the angle of its sidewalls - while there may be advantages for channel mobility, there may also be disadvantages from a gate depth perspective, where to reach a certain desired depth requires a fixed minimum trench top width. And finally, the corner of the V-shape or perhaps where the tapered sidewall meets any flat portion at the base will inherently provide an at least somewhat sharp corner, which can lead to field bunching.

Therefore, there is a need in the art for a plasma etch method which can etch a trench with tapered side walls in SiC whilst avoiding the need for thermally activated etching.

### Statement of Invention

The present invention, in at least some of its embodiments, seeks to address the above-described problems, desires and needs.

According to a first aspect of the present invention there is provided a method of plasma etching a silicon carbide substrate to form a tapered feature, the method comprising the steps of:
- providing a substrate with a hard mask formed thereon on a substrate support in a chamber, the hard mask having an opening, wherein the substrate is formed from silicon carbide;
- performing a plasma etch step to anisotropically etch the substrate through the opening to produce a tapered feature,
wherein the plasma etch step comprises generating a plasma from an etchant gas mixture comprising at least one chlorine-containing component, at least one inert gas component and at least one passivation material precursor and the anisotropic etching of the substrate comprise deposition of a passivation material on at least the opening such that the tapered feature comprises at least two sidewalls and each sidewall is inclined at an angle of less than 85° to the horizontal.

Without wishing to be bound by any theory or conjecture, it is believed that, by providing an etchant gas mixture comprising at least one chlorine-containing component, at least one inert gas component and at least one passivation material precursor, a highly anisotropic etch process can be performed whilst simultaneously depositing a passivation material on at least the opening in the hard mask, leading to an effective reduction in the critical dimension of the hard mask and a reduction in the etched width at the base of the trench. By controlling the deposition of the passivation material and the etch rate, the taper of the sidewalls can be closely controlled, even allowing for rounding of corners at the base of the trench, allowing for a combination of the advantages of a U-shaped trench and a V-shaped trench in a single etching step. The method of the present invention also displays high substrate-to-mask selectivity, allowing selectivities of up to 9:1 to be achieved.

The substrate can be a SiC wafer. The substrate can be a 150 mm SiC wafer. The hard mask can be formed from a material selected from SiOₓ and SiN.

The at least one passivation material precursor can comprise at least one silicon-containing component. The at least one silicon-containing component can comprise SiCl₄, SiF₄ or a combination thereof. The at least one silicon-containing component can comprise SiF₄. The at least one silicon-containing component can consist of or consist essentially of SiF₄. The at least one passivation material precursor can comprise at least one oxygen-containing component. The at least one oxygen-containing component can comprise O₂, N₂O, H₂O, O₃ or a combination thereof. The at least one oxygen-containing component can comprise O₂ gas. The at least one oxygen-containing component can consist of or consist essentially of O₂ gas. The at least one chlorine-containing component can comprise Cl₂, HCl, BCl₃ or a combination thereof. The at least one chlorine containing component can comprise Cl₂ gas. The at least one chlorine-containing component can consist of or consist essentially of Cl₂ gas. The at least one passivation material precursor can comprise C₄F₈. The at least one inert gas component can comprise helium, argon or a combination thereof. The at least one inert gas component can comprise argon. The at least one inert gas component can consist of or consist essentially of argon.

The total flow rate of the silicon-containing component at the beginning of the plasma etch step can be from about 10 sccm to about 50 sccm. The total flow rate of the at least one silicon-containing component can be about 39 sccm at the beginning of the plasma etch step and/or at the end of the plasma etch step. The total flow rate of the at least one oxygen-containing component at the beginning of the plasma etch step can be from about 12 sccm to about 75 sccm. The total flow rate of the at least one oxygen-containing component can be about 50 sccm at the beginning of the plasma etch step and/or at the end of the plasma etch step. The total flow rate of the at least one chlorine-containing component can be at least 100 sccm, such as at least 120 sccm. The total flow rate of the at least one chlorine-containing component can be about 120 sccm. The total flow rate of the at least one inert gas component can be from about 500 sccm to about 800 sccm. The total flow rate of the at least one inert gas component can be about 700 sccm. The ratio of the total flow rate of the at least one chlorine-containing component in sccm at the end of the plasma etch step to the total flow rate of the at least one passivation material precursor in sccm at the end of the plasma etch step can be from about 1:1 to about 3:1. The ratio of the total flow rate of the at least one chlorine-containing component in sccm at the end of the plasma etch step to the total flow rate of the at least one passivation material precursor in sccm at the end of the plasma etch step can be at least about 1:1.

The plasma etch step can comprise passivation material being deposited onto the hard mask and at least one sidewall of the feature being etched. The net deposition rate of the passivation material throughout the plasma etch step can be greater than zero. The passivation material can be deposited at a deposition rate that increases during the plasma etch step. The deposition rate of the passivation material can increase during the plasma etch step at an increasing rate of change. The dimension of the opening in the hard mask can reduce at an increasing rate of change. Increasing the deposition rate of the passivation material during the plasma etch step can help to produce a feature having both tapered side walls and rounded corners in the edge region of the bottom surface. For example, the feature can be a generally V-shaped trench with curved edges of the bottom surface. The passivation material can have a deposition thickness that increases to about 400 nm, optionally about 300 nm, optionally about 200 nm, optionally about 150 nm, or optionally about 125 nm on each side of the opening. The dimension of the opening in the hard mask can be reduced by about 100 to 800 nm, 200 to 600 nm, 250 to 500 nm, 300 to 400 nm, or about 350 nm or any combination of these upper and lower limits.

The plasma etch step can comprise varying a process parameter during the plasma etch step. The plasma etch step can comprise ramping a process parameter during the plasma etch step. The process parameter that is varied can be ramped at an increasing rate of change. The process parameter that is varied can be ramped at a constant rate of change. The term "ramping" can mean either systematically increasing or systematically decreasing a value.

The plasma etch step can comprise varying or ramping at least one of a gas mixture composition, a gas flow rate, a processing time, a plasma source power, a bias power applied to the substrate, and/or a frequency.

Varying the process parameter can comprise varying a flow rate of at least one passivation material precursor during the plasma etch step. The flow rate of the at least one passivation material precursor can be increased during the plasma etch step. The flow rate of the at least one passivation material precursor in sccm at the end of the plasma etch step can be at least two times, three times or four times higher than the flow rate of the at least one passivation material precursor in sccm at the beginning of the plasma etch step. The plasma etch step can comprise increasing a flow rate of the at least one oxygen-containing component during the plasma etch step. The flow rate of the at least one oxygen-containing component in sccm at the end of the plasma etch step can be at least two times, three times or four times higher than the flow rate of the at least one oxygen-containing component in sccm at the beginning of the plasma etch step. The flow rate of the at least one oxygen-containing component can be increased from about 12 sccm at the beginning of the plasma etch step to about 50 sccm at the end of the plasma etch step. The plasma etch step can comprise increasing a flow rate of the at least one silicon-containing component during the plasma etch step. The flow rate of the at least one silicon-containing component in sccm at the end of the plasma etch step can be at least two times, three times or four times higher than the flow rate of the at least one silicon-containing component in sccm at the beginning of the plasma etch step. The flow rate of the at least one silicon-containing component can be increased from about 10 sccm at the beginning of the plasma etch step to about 39 sccm at the end of the plasma etch step.

Varying the process parameter can comprise varying a bias power applied to the substrate during the plasma etch step. The plasma etch step can comprise decreasing the bias power applied to the substrate support during the plasma etch step. The bias power applied to the substrate support at the beginning of the plasma etch step can be higher than the bias power applied to the substrate support at the end of the plasma etch step by an amount in the range of about 50 to 1400 W. The bias power applied to the substrate at the beginning of the plasma etch step can be a power in the range of about 100 W to about 1500 W, about 1000 W to about 1400 W or about 1300 W. The bias power applied to the substrate at or towards the end of the plasma etch step can be a power in the range of about 50 W to about 1500 W. The initial bias power applied to the substrate support can be decreased by at least 50% during the plasma etch step, for example by at least 60%, at least 70%, at least 80% or at least 90%. Alternatively, the bias power applied to the substrate support during the plasma etch step can be maintained at a constant value throughout the plasma etch step. The bias power applied to the substrate support throughout the plasma etch step can be between 100 W and 1500 W. The bias power applied to the substrate support throughout the plasma etch step can be about 1300 W. Any other process parameter can be varied or ramped during the plasma etch step. Varying or ramping a process parameter can help to control the etch rate of the substrate through the opening whilst also controlling the deposition rate of the passivation material.

The plasma etch step can be performed using a plasma source that supplies a power of from 800 W to 2400 W to the plasma. The plasma source can supply a power of about 2400 W to the plasma during the plasma etch step.

The passivation material can comprise a silicon oxide, such as SiO_{X}. The passivation material is typically more resistant to the plasma etch process compared with the compound semiconductor material of the substrate. The etch selectivity between the substrate material and the passivation material can be in a range of about 5:1 to about 9:1. The passivation material and the hard mask can be made of substantially the same material.

The etch recipe used for the plasma etch step can consist of or consist essentially of at least one chlorine-containing component, at least one inert gas component (e.g. He and/or Ar) and one or more gases selected from the group: an oxygen-containing component (e.g. O₂) and/or at least one silicon-containing component (e.g. SiF₄ and/or SiCl₄). The plasma etch step can include using an etch recipe consisting of or consisting essentially of: Cl₂; O₂; SiF₄; and Ar.

The method of the first embodiment of the invention can further comprise a passivation removal step after the plasma etch step to remove passivation material that has formed on the substrate and the hard mask. The passivation removal step can be a wet etch, for example using an HF etchant. Alternatively, the passivation removal step can be a dry etch, comprising etching the substrate.

The dimension of the opening in the hard mask prior to the plasma etch step can be in a range of about 0.5 µm to 10 µm or about 1 µm to 8 µm. The dimension of the opening can be a width. The feature can have a maximum width in the range of about 0.5 µm to 10 µm. The feature can have a depth in the range of about 0.5 µm to 3 µm.

The tapered feature can be a trench. The tapered feature can be a via. The bottom surface of the tapered feature can be substantially flat. The bottom surface of the fully formed tapered feature can be substantially concave. The term "substantially concave" is used here to mean a shape in which it is possible to draw a line segment between two points on opposite sides of the bottom surface (e.g. from opposing edge regions) without intersecting the substrate (i.e. having a central region that is deeper than the edge region). This definition includes a concave profile comprising a flat central region. This definition includes a concave profile having tapered corners. The present invention allows the profile of the bottom surface to be tailored as desired by the user.

The central region of the bottom surface of the fully formed tapered feature can be substantially flat. The edge region can provide a continuous change in slope from the central region to at least one tapered sidewall of the tapered feature. The edge region can extend from the sidewall of the feature by a distance in the range of about 100 nm to about 350 nm, about 125 nm to about 300 nm, about 150 nm to about 250 nm, or optionally about 175 nm. The edge region of the bottom surface of the fully formed tapered feature can comprise a curved surface. The edge region can form a rounded corner between the central region of the bottom surface and a sidewall of the tapered feature. The edge region can form a tapered corner between the central region of the bottom surface and a sidewall of the tapered feature.

The chamber can be cooled by water cooling. The chamber can be cooled to a temperature of about 55 °C. The substrate support can be maintained at a temperature of between 5 °C and 50 °C. The substrate support can be maintained at a temperature of about 10 °C. The pressure within the chamber during the plasma etch step can be from 2 mTorr (0.267 Pa) to 60 mTorr (8.00 Pa). The pressure within the chamber during the plasma etch step can be about 12 mTorr (1.60 Pa).

The plasma etch step can be performed using an inductively coupled plasma (ICP) etch apparatus. The passivation removal step can also be performed using an inductively coupled plasma (ICP) etch apparatus.

According to a second aspect of the present invention, there is provided a silicon carbide substrate comprising at least one tapered feature produced by the method of the first aspect of the present invention, the at least one tapered feature comprising at least two sidewalls, wherein each sidewall is inclined at an angle of less than 85° to the horizontal.

The silicon carbide substrate can be a SiC wafer. The silicon carbide substrate can be a 150 mm SiC wafer. Each sidewall can be inclined at an angle of 81° to the horizontal or less. Each sidewall can be inclined at an angle of 74° to the horizontal or less.

According to a third aspect of the present invention there is provided a plasma etch apparatus for plasma etching a silicon carbide substrate to form a tapered feature using the method according to the first aspect, the apparatus comprising:
- a chamber;
- a substrate support disposed within the chamber for supporting a substrate thereon;
- at least one gas inlet for introducing a gas or gas mixture into the chamber at a flow rate;
- a plasma generating means for sustaining a plasma in the chamber;
- a power supply for supplying an electrical bias power to the substrate support; and
- a controller configured to operate the plasma etch apparatus to generate a plasma from an etchant gas mixture comprising at least one chlorine-containing component, a least one inert gas component and at least one passivation material precursor.

The at least one gas inlet can comprise a first gas inlet for introducing at least one chlorine-containing component into the chamber, a second gas inlet for introducing at least one inert gas component into the chamber and a third gas inlet for introducing at least one passivation material precursor into the chamber, and the controller can be configured to form an etchant gas mixture in the chamber comprising at least one chlorine-containing component, at least one inert gas component and at least one passivation material precursor to generate a plasma from the etchant gas mixture. The at least one gas inlet can comprise a fourth gas inlet for introducing a further passivation material precursor into the chamber, and the controller can be configured to form an etchant gas mixture in the chamber comprising the at least one chlorine-containing component, at least one inert gas component and at least two passivation material precursors and generate a plasma from the etchant gas mixture. The at least one gas inlet can comprise at least one further gas inlet, such as a fifth gas inlet, for introducing at least one further gas or gas mixture into the chamber, and the controller can be configured to form an etchant gas mixture in the chamber comprising the at least one chlorine-containing component, at least one inert gas component, at least two passivation material precursors and the at least one further gas or gas mixture and generate a plasma from the etchant gas mixture. The controller can be configured to change at least one of a flow rate and/or the power generated by the power supply for supplying an electrical bias power to the substrate support whilst a plasma is generated in the chamber. The controller can be configured to change a flow rate through at least one of the first gas inlet, second gas inlet, third gas inlet and/or fourth gas inlet. The third gas inlet or the fourth gas inlet can be for introducing at least one oxygen-containing component into the chamber, and the controller can be configured to change a flow rate of the at least one oxygen-containing component. The plasma generating means can comprise a plasma source.

For the avoidance of doubt, whenever reference is made herein to 'comprising' or 'including' and like terms, the invention is also understood to include more limiting terms such as 'consisting of' and 'consisting essentially of'.

Whilst the invention has been described above, it extends to any inventive combination of the features set out above, or in the following description, drawings or claims. For example, any features disclosed in relation to the first aspect of the invention may be combined with any features of the second aspect of the invention and *vice versa.*

### Description of Figures

Aspects of methods and apparatuses in accordance with the invention will now be described with reference to the accompanying drawings, in which:
Figure 1 is a schematic representation of a plasma etch apparatus in accordance with an embodiment of the invention;
Figure 2 is a schematic representation of A) a rectangular-sectioned trench, B) a round-based or "U-shaped" trench and C) a tapered or "V-shaped" trench;
Figure 3 is a flow chart illustrating a method in accordance with an embodiment of the invention;
Figure 4 is a schematic representation of an etching process as part of the method in accordance with an embodiment of the invention; and
Figure 5 is an SEM image of trenches formed in SiC with tapered sidewalls before and after an in-situ plasma passivation removal step.

### Detailed Description

Figure 1 shows a schematic representation of a plasma etch apparatus 20 in accordance with the second embodiment of the invention suitable for performing methods according to the first embodiment of the present invention. Plasma etching of a substrate is performed using a suitable plasma etch apparatus. The plasma etch apparatus can be an inductively coupled plasma (ICP) apparatus. However, etching can also be performed using other dry etch systems, such as helicon, RIE or microwave type apparatus. The operation of generating a plasma within such plasma etch apparatus is well-known in the art and will not be described here other than where necessary for an understanding of the present invention.

A plasma etching tool suitable for performing the method of the present invention is an Omega (RTM) Synapse^{™} available from SPTS Technologies Limited of Newport, UK. A plasma etch apparatus 20 typically comprises a substrate support (or platen) 22, also known as a wafer support, disposed within a chamber 23 for supporting a substrate. A bias power can be supplied to the substrate by a RF power supply 250 via an impedance matching network (not shown) and an electrode 252. Typical RF frequencies for operation of the RF power supply may be between about 380 kHz and 13.56 MHz. Process gases can be introduced into the chamber via one or more gas inlets 25, 26. In one embodiment, at least six gas inlets can be present. However, in the illustrated embodiment, two gas inlets 25, 26 are provided, and the gases from which the plasma is generated are introduced to the chamber 23 through the two gas inlets 25, 26. A plasma generating means 28, such as an inductive coil, can be used to generate and sustain a plasma within the chamber 23 as is known in the art (e.g. using a RF power supply and impedance matching network). In the illustrated embodiment, the plasma generating means is an RF inductive coil 28 contained within a housing 29. The gases can be removed from the chamber 23 via a pumping port 27. Also provided is a controller (not shown) which is configured to control the apparatus to perform the process sequence described herein.

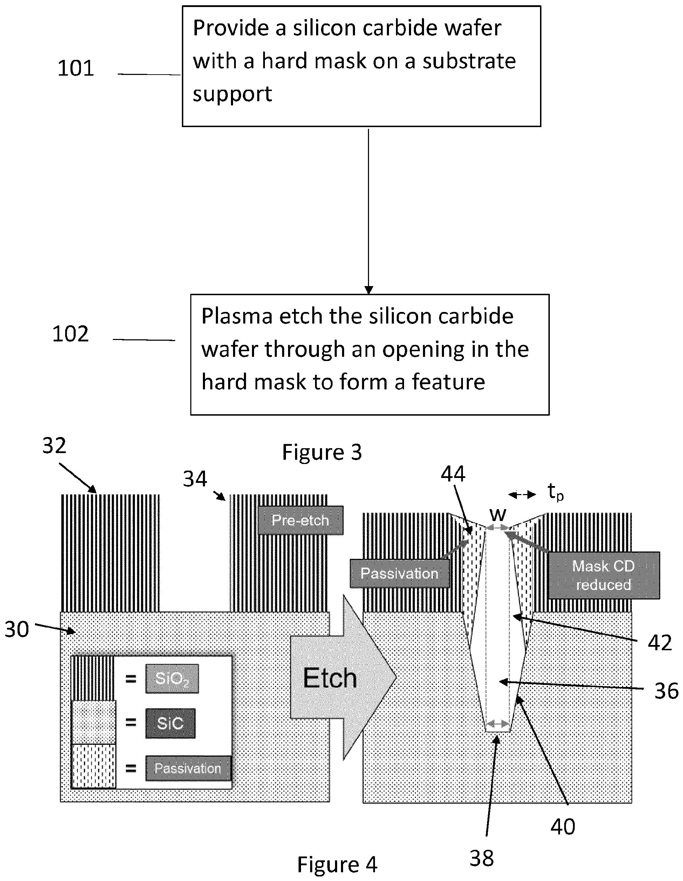

Figures 3 and 4 show the stages of an exemplary method according to a first aspect of the first embodiment of the present invention.

In the exemplary method, a silicon carbide (SiC) semiconductor substrate 30 is etched to form a feature. In the exemplary method, the feature is a trench, and the substrate 30 is a 150 mm silicon carbide wafer. However, other features may be formed and other compound semiconductor substrates can alternatively be used in the method of the first embodiment of the present invention. Other wafer sizes may also be used in the method of the first aspect of the first embodiment of the present invention. Although the parameters stated below are those used for the etching of a 150 mm SiC wafer, they may be varied with the size of the wafer in a manner known in the art.

The substrate 30 includes a patterned hard mask layer 32, comprising at least one opening 34 in the hard mask 32 exposing the substrate 30 underneath the hard mask 32. The hard mask 32 can be formed from a layer of silicon oxide (SiO_{X}) or other suitable hard mask material, such as SiN. The hard mask 32 is typically more resistant to the plasma etch conditions than the silicon carbide.

In a first step 101, the substrate 30 to be etched is positioned on the substrate support 22 in a plasma etch apparatus 20 with the face to be etched facing upwards. A pre-etch can optionally be performed to prepare the substrate 30 prior to the plasma etch, for example to remove unwanted material from the openings 34 of the hard mask 32.

In a second step 102, a plasma etch step is performed to selectively etch the SiC substrate 30 so that the trench structure 36 is formed. The plasma etch step 102 comprises generating a plasma from an etchant gas mixture to anisotropically etch the substrate 30 in the areas of the substrate 30 that are not covered by the hard mask 32. Simultaneously, a passivation material 44 is deposited onto at least the opening 34 of the hard mask 32 and optionally also at least one sidewall 40 of the trench 36 being etched. The passivation material 44 can be a silicon oxide, such as SiO_{X}. The passivation material 44 and the mask can be made from the same material. Without wishing to be bound by any theory or conjecture, it is believed that the thickness (*tₚ*) of the passivation material 44 gradually increases during the plasma etch step 102 up to a thickness of 400nm, which has the effect of gradually reducing a dimension in the opening 34 of the hard mask 32 or feature 36. The dimension can be a critical dimension and can correspond to the minimum width (w) of the opening 34 in the hard mask 32. As the dimension of the opening 34 is reduced, the etching at a peripheral region of the base 38 of the trench 36 is attenuated. The change in the dimension w translates to a reduction in the etched width at the base 38 of the feature 36. Without wishing to be bound by any theory or conjecture, it is believed that the passivation material 44 overhangs the corners of the base of the feature and consequently shields the corners of the base 38 of the feature 36 from the highly directional anisotropic plasma etch process. This has the effect of reducing the etch rate at the peripheral region of the base 38 (compared to a central region of the base 38) as the etching progresses. By controlling the deposition of the passivation material (and hence by controlling the dimension of the opening in the mask) it is possible to control the profile of the feature as desired.

A bias power is applied to the platen 22 during the plasma etch step 102. For example, the bias power applied to the platen can be in the range of about 100 W to about 1500 W, optionally about 1300 W. This helps to impart a directionality to the species (e.g. ions) in the plasma so that the base 38 of the trench 36 is preferentially etched (rather than the sidewalls 40 of the trench).

The etchant gas mixture comprises at least one chlorine-containing component, at least one inert gas component and at least one passivation material precursor. In an exemplary embodiment, the etchant gas mixture used to generate the plasma consists of Cl₂ gas as the at least one chlorine-containing component, SiF₄ and O₂ gases as the two passivation material precursors and Ar gas as the at least one inert gas component. At the beginning of the plasma etch step 102, the SiF₄ flow rate can be from 25 sccm to 50 sccm, the Cl₂ flow rate can be at least 100 sccm, for example 120 sccm, the O₂ flow rate can be from 12 sccm to 75 sccm and the Ar flow rate can be from 500 sccm to 800 sccm.

The present inventors have found that the etchant gas mixture comprising at least one chlorine-containing component, at least one inert gas component and at least one passivation material precursor can be used to reduce the resultant trench profile angle whilst maintaining desired etch characteristics such as etch rate and substrate-to-mask selectivity. Without wishing to be bound by any theory or conjecture, it is believed that the combination of the strong anisotropic etch provided by the at least one inert gas species and the chemical etch provided by the at least one chlorine-containing species, in combination with the build-up of passivation material on at least the opening 34 of the hard mask 32 from the at least one passivation material precursor, in a single etching step 102, allowing for the formation of tapered, or "V-shaped", features in an efficient process. This effect is particularly pronounced where the total flow rate (in sccm) of the at least one chlorine-containing component is at least as large as the total flow rate (in sccm) of the at least one passivation material precursor.

During the plasma etch step, the chamber pressure can be in the range of about 2 mTorr (0.267 Pa) to about 60 mTorr (8.00 Pa), optionally about 12 mTorr (1.60 Pa). During the plasma etch step, the plasma source power can be in the range of about 800 W to about 2400 W, optionally about 2400 W. During the plasma etch step, the bias power applied to the substrate can be a RF bias power. RF frequencies for the RF bias power can be between about 2 MHz and about 13.56 MHz. Typically, the platen 22 temperature setpoint is between about 5 °C and about 50 °C, preferably about 10 °C, whilst the chamber walls are cooled to a temperature of about 55 °C using water. A platen temperature of around 10 °C and a chamber wall temperature of about 55 °C is typically used due to the presence of chlorine in the etchant gas mixture.

During the plasma etch step 102, one or more parameters may be changed, or "ramped", in order to alter the plasma etch conditions and alter the final profile of the etched feature 36. For example, the flow rate (in sccm) of the at least one passivation material precursor, such as O₂ and/or SiF₄, can be four times higher at the end of the plasma etch step 102 than at the beginning of the plasma etch step 102. Increased passivation material precursor (such as O₂) flow causes high deposition rates, so starting with low flow and increasing over time increases the deposition rate of passivation material 44. In another example, the bias power applied to the substrate support 22, can be decreased during the plasma etch step 102, such that the final bias power can be between about 50 W to 1400 W lower than the bias power at the beginning of the plasma etch step 102. Reduction in bias power aids passivation material deposition, so starting with a high power and reducing it over time increases the passivation material build-up rate. The changes in these one or more parameters can be changed over time can be linear or have varying degrees of non-linearity, with parameters beginning the process at relatively constant values and strongly varying towards the end, or vice-versa.

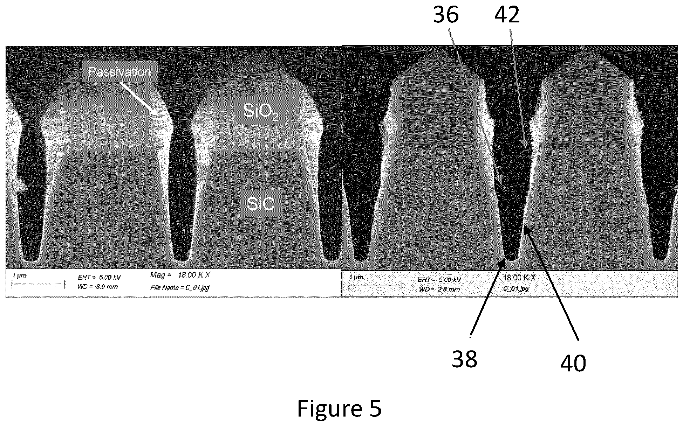

The plasma etch step 102 results in the formation of a trench 36, as shown in Figures 4 and 5. The trench 36 comprises a base 38 that is approximately parallel to the surface of the substrate 30 on which the hard mask 32 is formed. The trench 36 further comprises an opening 42 adjacent to the surface of the substrate 30 on which the mask 32 is formed.

The trench 36 further comprises tapered sidewalls 40 between the base 38 and the opening 42 of the trench 36. The tapered sidewalls 40 have a taper of less than 85 ° to the horizontal, which is the plane perpendicular to the direction of anisotropic etching.

The duration of the plasma etch step depends on the thickness of the substrate 30 and the desired dimensions of the trench 36 in a manner known in the art.

The trench 36 can be subjected to a number of post-processing steps as shown in Figure 5, such as mask removal, smoothing or polishing to provide the final feature.

### Example

An exemplary set of process parameters for the plasma etch step of the method of the first embodiment are shown in Table 1. The exemplary process was performed in the modified Omega (RTM) Synapse^{™} etch apparatus with source and bias RF power supplies operating at 13.56 MHz.

**Table 1**

| Process Parameter | Plasma Etch |
|---|---|
| Process Duration (s) | 240 |
| Pressure (mTorr) | 12 |
| ICP Source Power (Watts) | 2400 |
| Platen power (Watts) | 1300 |
| Ar flow (sccm) | 700 |
| O₂ flow (sccm) | 50 |
| Cl₂ flow (sccm) | 120 |
| SiF₄ flow (sccm) | 39 |
| Backside Helium Pressure (Torr) | 10 |
| Platen Temperature (°C) | 10 |

Using this process, an etch rate of 520 nm/min and a selectivity over substrate to hard mask of 9:1 was achieved, with a final sidewall taper angle of 81 ° to the horizontal. Replacing the Cl₂ with SF₆ was shown to produce a trench with similar process conditions, but with a sidewall taper angle of between 88 ° and 89 °. Similarly, removal of the Cl₂ gas from the etchant gas mixture resulted in an etch rate as low as 70 nm/min, due to a lack of available etch species.

By controlling the deposition rate of the passivation material, and hence by controlling the thickness of the passivation material, the dimension of the opening in the hard mask can be controlled. Control of this dimension allows the width of the etch at the base of the feature to be controlled and can enable the shape and profile of the feature as a whole and of the bottom surface of the feature being etched to be controllably varied. Furthermore, controlling the deposition rate of the passivation material allows control of the profile of the edges at the base of the feature. Particular advantages are associated with a feature comprising a base with rounded corners. A rounded (or curved) corner can more uniformly distribute electric fields and therefore reduce field bunching. This can beneficially maximise breakdown voltages.

## Claims

1. A method of plasma etching a silicon carbide substrate to form a tapered feature, the method comprising the steps of:
• providing a substrate with a hard mask formed thereon on a substrate support in a chamber, the hard mask having an opening, wherein the substrate is formed from silicon carbide;
• performing a plasma etch step to anisotropically etch the substrate through the opening to produce a tapered feature,
wherein the plasma etch step comprises generating a plasma from an etchant gas mixture comprising at least one chlorine-containing component, at least one inert gas component and at least one passivation material precursor and the anisotropic etching of the substrate comprise deposition of a passivation material on at least the opening such that the tapered feature comprises at least two sidewalls and each sidewall is inclined at an angle of less than 85° to the horizontal.

2. A method according to claim 1, wherein the at least one passivation material precursor comprises at least one silicon-containing component and optionally wherein the total flow rate of the at least one silicon-containing component at the beginning of the plasma etch step is from about 10 sccm to about 50 sccm.

3. A method according to claim 2, wherein the at least one silicon-containing component comprises SiCl₄, SiF₄ or a combination thereof.

4. A method according to any one of claims 1 to 3, wherein the at least one passivation material precursor comprises at least one oxygen-containing component and optionally wherein the total flow rate of the at least one oxygen-containing component at the beginning of the plasma etch step is from about 12 sccm to about 75 sccm.

5. A method according to claim 4, wherein the at least one oxygen-containing component comprises O₂ gas.

6. A method according to any one of claims 1 to 5, wherein the plasma etch step comprises increasing a flow rate of the at least one passivation material precursor during the plasma etch step and optionally wherein the flow rate of the at least one passivation material precursor in sccm at the end of the plasma etch step is at least two times higher than the flow rate of the at least one passivation material precursor in sccm at the beginning of the plasma etch step.

7. A method according to any one of claims 1 to 6, wherein the at least one chlorine-containing component comprises Cl₂ gas.

8. A method according to any one of claims 1 to 7, wherein the at least one inert gas component comprises helium, argon or a combination thereof and/or wherein the total flow rate of the at least one inert gas component is from about 500 sccm to about 800 sccm.

9. A method according to any one of claims 1 to 8, wherein each sidewall is inclined at an angle of 81° to the horizontal or less, optionally wherein each sidewall is inclined at an angle of 74° to the horizontal or less.

10. A method according to any one of claims 1 to 9, wherein (a) the ratio of the total flow rate of the at least one chlorine-containing component in sccm at the end of the plasma etch step to the total flow rate of the at least one passivation material precursor in sccm at the end of the plasma etch step is from about 1:1 to about 3:1; and/or (b) the total flow rate of the at least one chlorine-containing component is at least 100 sccm; and/or (c) the plasma etch step is performed using a plasma source that supplies a power of from about 800 W to about 2400 W to the plasma; and/or (d) an initial bias power of from 100 W to 1500 W is applied to the substrate support during the plasma etch step.

11. A method according to any one of claims 1 to 10, wherein the plasma etch step comprises decreasing the bias power applied to the substrate support during the plasma etch step and optionally wherein the initial bias power applied to the substrate support is decreased by at least 50% during the plasma etch step.

12. A method according to claim any one of claims 1 to 11, wherein the substrate support is maintained at a temperature of between about 5 °C and about 50 °C and/or wherein the pressure within the chamber during the plasma etch step is from 2 mTorr (0.267 Pa) to 60 mTorr (8.00 Pa).

13. A plasma etch apparatus for plasma etching a silicon carbide substrate to form a tapered feature using the method according to any one of claims 1 to 12, the apparatus comprising:
• a chamber;
• a substrate support disposed within the chamber for supporting a substrate thereon;
• at least one gas inlet for introducing a gas or gas mixture into the chamber at a flow rate;
• a plasma generating means for sustaining a plasma in the chamber;
• a power supply for supplying an electrical bias power to the substrate support; and
• a controller configured to operate the plasma etch apparatus to generate a plasma from an etchant gas mixture comprising at least one chlorine-containing component, a least one inert gas component and at least one passivation material precursor.

14. An apparatus according to claim 13, wherein (a) the at least one gas inlet comprises a first gas inlet for introducing at least one chlorine-containing component into the chamber, a second gas inlet for introducing at least one inert gas component into the chamber and a third gas inlet for introducing at least one passivation material precursor into the chamber, and the controller is configured to form an etchant gas mixture in the chamber comprising at least one chlorine-containing component, at least one inert gas component and at least one passivation material precursor to generate a plasma from the etchant gas mixture; and/or (b) the at least one gas inlet comprises a fourth gas inlet for introducing a further passivation material precursor into the chamber, and the controller is configured to form an etchant gas mixture in the chamber comprising the at least one chlorine-containing component, at least one inert gas component and at least two passivation material precursors and generate a plasma from the etchant gas mixture.

15. An apparatus according to claim 13 or claim 14, wherein the controller is configured to change at least one of a flow rate and/or the power generated by the power supply for supplying an electrical bias power to the substrate support whilst a plasma is generated in the chamber.
